# EUROPEAN PATENT SPECIFICATION

(11) **EP 2 450 908 B1**
(45) Date of publication and mention of the grant of the patent: **03.07.2019**
(21) Application number: 11177515.1
(22) Date of filing: 12.08.2011
(51) Int. Cl.: H01B 1/22, H01L 31/0224, H01L 31/068

(54) **Conductive paste, electrode and electronic device and solar cell including an electrode formed using the conductive paste**
Leitfähige Paste, Elektrode und elektronische Vorrichtung sowie Solarzelle mit einer anhand der leitfähigen Paste hergestellten Elektrode
Pâte conductrice, électrode et dispositif électronique et cellule solaire incluant une électrode formée utilisant la pâte conductrice

(30) Priority: 13.08.2010 KR 20100078344; 06.07.2011 KR 20110066739
(43) Date of publication of application: 09.05.2012
(73) Proprietor: Samsung Electronics Co., Ltd., Suwon-si, Gyeonggi-do, 443-742 (KR)
(72) Inventor: Kim, Se Yun, Seoul (KR); Lee, Eun-Sung, Seoul (KR); Jee, Sang Soo, Hwaseong-si Gyeonggi-do (KR); Lee, Sang-Mock, Yongin-si Gyeonggi-do (KR)
(74) Representative: Elkington & Fife LLP

(56) References cited:
- EP-A1- 2 416 327
- EP-A2- 2 325 848
- EP-A2- 2 448 003
- US-A1- 2005 211 340
- US-A1- 2010 096 014
- WANG X ET AL: "Atomic structure and glass forming ability of Cu46Zr46Al8 bulk metallic glass", JOURNAL OF APPLIED PHYSICS, AMERICAN INSTITUTE OF PHYSICS. NEW YORK, US, vol. 104, no. 9, 7 November 2008 (2008-11-07), pages 93519-93519, XP012118047, ISSN: 0021-8979, DOI: 10.1063/1.3009320

## Description

### BACKGROUND

### 1. Field

This disclosure relates to a conductive paste, an electrode formed using the conductive paste and an electronic device and a solar cell including said electrode.

### 2. Description of the Related Art

A solar cell is a photoelectric conversion device that transforms solar energy into electrical energy. Solar cells have attracted much attention as a potentially infinite and essentially pollution-free next generation energy source.

A solar cell includes p-type and n-type semiconductors. When an electron-hole pair ("EHP") is produced by light absorbed in a photoactive layer of the semiconductors, the solar cell produces electrical energy by transferring electrons and holes to the n-type and p-type semiconductors, respectively, and then collects the electrons and the holes in respective electrodes of the solar cell.

A solar cell desirably has as high efficiency as possible for producing electrical energy from solar energy. In order to improve this efficiency, the solar cell desirably absorbs light with minimal loss, so that it may produce as many electron-hole pairs as possible, and then collect the produced charges without significant loss.

An electrode may be fabricated using a deposition method, which may include a complicated process, have a high cost, and can take a long time. Accordingly, a simplified process, such as screen printing a conductive paste including a conductive material, has been suggested. However, an electrode formed using a conductive paste may have low conductivity because of a glass frit included in a conductive paste. Thus there remains a need for an improved conductive paste.

EP 2 416 327 A1, which is prior art for the assessment of novelty only, discloses a conductive paste including a conductive powder, a metallic glass having a supercooled liquid region and an organic vehicle.

EP 2 325 848, which is prior art for the assessment of novelty only, discloses a conductive paste including a conductive powder, a metallic glass disposed between adjacent conductive particles of the conductive powder and an organic vehicle.

US 2010/096014 A1 discloses a conductive paste including conductive particles, glass frits, and organic binder and a solvent.

### SUMMARY

An embodiment provides a conductive paste which is capable of improving conductivity of an electrode.

An embodiment provides an electrode including the fired conductive paste.

Another embodiment provides an electronic device including an electrode including the fired conductive paste.

Yet another embodiment provides a solar cell including an electrode including the fired conductive paste.

According to an embodiment, disclosed is a conductive paste including a conductive powder, a metallic glass, and an organic vehicle. Herein, the metallic glass includes an alloy of at least two elements selected from an element having a low resistivity, an element which forms a solid solution with the conductive powder, an element having a high oxidation potential, wherein the element having a low resistivity has a resistivity of less than about 100 microohm-centimeters, and the element having a high oxidation potential has an absolute value of a Gibbs free energy of oxide formation of about 100 kiloJoules per mole or greater, and wherein the metallic glass is not Cu₅₀Zr₅₀, Cu₃₀Ag₃₀Zr₃₀Ti₁₀, Cu₄₃Zr₄₃Al₇Ag₇, Cu₄₆Zr₄₆Al₈, Cu_{58.1}Zr_{35.9}Al₆, Ti₅₀Ni₁₅Cu₃₂Sn₃, Ti₄₅Ni₁₅Cu₂₅Sn₃Be₇Zr₅, Ni₆₀Nb₃₀Ta₁₀, Ni₆₁Zr₂₀Nb₇Al₄Ta₈, Ni_{57.5}Zr₃₅Al_{7.5}, Zr_{41.2}Ti_{13.8}Ni₁₀Cu_{12.5}Be_{22.5}, Mg₆₅Y₁₀Cu₁₅Ag₅Pd₅, Mn₅₅Al₂₅Ni₂₀, La₅₅Al₂₅Ni₁₀Cu₁₀,
Mg₆₅Cu_{7.5}Ni_{7.5}Ag₅Zn₅Gd₁₀, Mg₆₅Cu₁₅Ag₁₀Y₆Gd₄,
Fe₇₇Nb₆B₁₇, Fe₆₇Mo₁₃B₁₇Y₃, Ca₆₅Mg₁₅Zn₂₀, or Ca_{66.4}Al_{33.6}.

The conductive powder may include a silver, an aluminum, a copper, a nickel or a combination thereof.

The conductive powder may have a size range from about 1 nm to about 50 µm.

The element having a low resistivity may have a resistivity of less than about 15 microohm-centimeters.

The element having a low resistivity may include at least one selected from silver (Ag), copper (Cu), gold (Au), aluminum (Al), calcium (Ca), beryllium (Be), magnesium (Mg), sodium (Na), molybdenum (Mo), tungsten (W), tin (Sn), zinc (Zn), nickel (Ni), potassium (K), lithium (Li), iron (Fe), palladium (Pd), platinum (Pt), rubidium (Rb), chromium (Cr), and strontium (Sr).

The element which forms a solid solution with the conductive powder may have a heat of mixing with the conductive powder of less than 0 kJ/mol.

The element which forms a solid solution with the conductive powder may include at least one selected from lanthanum (La), cerium (Ce), praseodymium (Pr), promethium (Pm), samarium (Sm), lutetium (Lu), yttrium (Y), neodymium (Nd), gadolinium (Gd), terbium (Tb), dysprosium (Dy), holmium (Ho), erbium (Er), thulium (Tm), thorium (Th), calcium (Ca), scandium (Sc), barium (Ba), ytterbium (Yb), strontium (Sr), europium (Eu), zirconium (Zr), lithium (Li), hafnium (Hf), magnesium (Mg), phosphorus (P), arsenic (As), palladium (Pd), gold (Au), plutonium (Pu), gallium (Ga), germanium (Ge), aluminum (Al), zinc (Zn), antimony (Sb), silicon (Si), tin (Sn), titanium (Ti), cadmium (Cd), indium (In), platinum (Pt), rhodium (Rh), iridium (Ir), uranium (U), nickel (Ni), ruthenium (Ru), technetium (Tc), manganese (Mn), cobalt (Co), tantalum (Ta), niobium (Nb), osmium (Os), vanadium (V), iron (Fe), chromium (Cr), rhenium (Re), molybdenum (Mo), silver (Ag), tungsten (W), beryllium (Be), boron (B), copper (Cu), and mercury (Hg).

The element having a high oxidation potential may include at least one selected from copper, titanium, ruthenium, cadmium, zinc, rhodium, potassium, sodium, nickel, bismuth, tin, barium, germanium, lithium, strontium, magnesium, beryllium, lead, calcium, molybdenum, tungsten, cobalt, indium, silicon, gallium, iron, zirconium, chromium, boron, manganese, aluminum, lanthanum, neodymium, niobium, vanadium, yttrium, and scandium.

The conductive powder, the metallic glass, and the organic vehicle may be included in an amount of about 30 to about 99 weight percent (wt%), about 0.1 to about 20 weight percent (wt%), and about 0.9 to about 69.9 weight percent (wt%), based on the total weight of the conductive paste.

The metallic glass may be substantially amorphous.

The metallic glass may have a supercooled liquid region of about 5°C to about 200°C.

The metallic glass may include copper (Cu) and zirconium (Zr). In this case, the metallic glass may further include at least one selected from aluminum (Al), silver (Ag), nickel (Ni), titanium (Ti), iron (Fe), palladium (Pd), and hafnium (Hf). At least one selected from aluminum (Al), silver (Ag), nickel (Ni), titanium (Ti), iron (Fe), palladium (Pd), and hafnium (Hf) may be included in an amount of about 10 atomic percent (at%) or less, based on the total amount of the metallic glass.

According to another embodiment, an electrode is formed using the conductive paste.

The electrode may have a contact resistance of about 1 KΩcm² or less.

The electrode may have a resistivity of about 10 mΩcm or less.

According to another embodiment, an electronic device includes an electrode formed using the conductive paste.

According to another embodiment, a solar cell includes a semiconductor substrate and an electrode electrically connected with the semiconductor substrate and formed using the conductive paste.

The electrode may include a buffer layer positioned at a region which is adjacent to the semiconductor substrate, and an electrode portion which is positioned at a region except the buffer layer.

### BRIEF DESCRIPTION OF THE DRAWINGS

The above and other aspects, advantages and features of this disclosure will become more apparent by describing in further detail exemplary embodiments thereof with reference to the accompanying drawings, in which:
FIGS. 1 to 3 are a schematic diagram of an embodiment of heat treating a conductive powder and a metallic glass on a semiconductor substrate;
FIGS. 4A to 4C are a schematic diagram showing an expanded view of region A of FIG. 3;
FIG. 5 is a cross-sectional view of an embodiment of a solar cell; and
FIG. 6 is a cross-sectional view of another embodiment of a solar cell.

### DETAILED DESCRIPTION

Exemplary embodiments will hereinafter be described in further detail with reference to the accompanying drawings, in which various embodiments are shown. This disclosure may, however, be embodied in many different forms and should not be construed as limited to the exemplary embodiments set forth herein.

As used herein, the term "and/or" includes any and all combinations of one or more of the associated listed items. It will be understood that, although the terms "first," "second," "third" etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, "a first element," "component," "region," "layer," or "section" discussed below could be termed a second element, component, region, layer, or section without departing from the teachings herein.

The terminology used herein is for the purpose of describing particular embodiments only and is not intended to be limiting. As used herein, the singular forms "a," "an" and "the" are intended to include the plural forms as well, unless the context clearly indicates otherwise. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof. The term "at least one" means a combination comprising one or more of the listed components may be used.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

"Alkyl" means a straight or branched chain saturated aliphatic hydrocarbon having 1 to 12 carbon atoms, more specifically 1 to 6 carbon atoms.

Herein, the term 'element' refers to a metal and a semimetal.

First, disclosed is a conductive paste.

The conductive paste according to an embodiment includes a conductive powder, a metallic glass, and an organic vehicle.

The conductive powder may include at least one metal or alloy selected from a silver (Ag)-containing metal such as silver or a silver alloy, an aluminum (Al)-containing metal such as aluminum or an aluminum alloy, a copper (Cu)-containing metal such as copper (Cu) or a copper alloy, a nickel (Ni)-containing metal such as nickel (Ni) or a nickel alloy, or a combination thereof. However, the conductive powder is not limited thereto but may include other metals, an additive that is not the metal or alloy.

The conductive powder may have a size (e.g., average largest particle size) ranging from about 1 nanometers (nm) to about 50 micrometers (µm), specifically about 0.1 µm to about 40 µm, specifically about 0.5 µm to about 40 µm, more specifically about 1 µm to about 30 µm. Particles of the conductive powder may be irregular, or have a spherical, rod-like, or plate-like shape.

The metallic glass includes an alloy having a disordered atomic structure including two or more elements. The metallic glass may be an amorphous metal. The metallic glass may have about 50 to about 100 weight percent ("wt%"), specifically about 70 to about 100 wt%, more specifically about 90 to about 100 wt% amorphous content, based on a total weight of the metallic glass. Because the metallic glass has a low resistivity, and thus is different from an insulating glass such as a silicate, it may be considered to be an electrical conductor at a voltage and a current of a solar cell.

The metallic glass is an alloy of at least two elements selected from an element which has a low resistivity, an element which is capable of forming a solid solution with the conductive powder, an element which has a high oxidation potential. The element which has a low resistivity has a resistivity of less than about 100 microohm-centimeters, and the element which has a high oxidation potential has an absolute value of a Gibbs free energy of oxide formation of about 100 kiloJoules per mole or greater, wherein the metallic glass is not Cu₅₀Zr₅₀, Cu₃₀Ag₃₀Zr₃₀Ti₁₀, Cu₄₃Zr₄₃Al₇Ag₇, Cu₄₆Zr₄₆Al₈, Cu_{58.1}Zr_{35.9}Al₆, Ti₅₀Ni₁₅Cu₃₂Sn₃, Ti₄₅Ni₁₅Cu₂₅Sn₃Be₇Zr₅, Ni₆₀Nb₃₀Ta₁₀, Ni₆₁Zr₂₀Nb₇Al₄Ta₈, Ni_{57.5}Zr₃₅Al_{7.5}, Zr_{41.2}Ti_{13.8}Ni₁₀Cu_{12.5}Be_{22.5}, Mg₆₅Y₁₀Cu₁₅Ag₅Pd₅,
Mn₅₅Al₂₅Ni₂₀, La₅₅Al₂₅Ni₁₀Cu₁₀,
Mg₆₅Cu_{7.5}Ni_{7.5}Ag₅Zn₅Gd₁₀,
Mg₆₅Cu₁₅Ag₁₀Y₆Gd₄, Fe₇₇Nb₆B₁₇, Fe₆₇Mo₁₃B₁₇Y₃, Ca₆₅Mg₁₅Zn₂₀, or Ca_{66.4}Al_{33.6}.

The element, which has a low resistivity, may substantially determine the conductivity of the metallic glass. The element having a low resistivity may have a resistivity of about 0.001 to about 90 µΩcm, specifically about 0.01 to about 50 µΩcm. In an embodiment, the element having a low resistivity may have resistivity of less than about 15 µΩcm.

The element having a low resistivity may include, for example, at least one selected from silver (Ag), copper (Cu), gold (Au), aluminum (Al), calcium (Ca), beryllium (Be), magnesium (Mg), sodium (Na), molybdenum (Mo), tungsten (W), tin (Sn), zinc (Zn), nickel (Ni), potassium (K), lithium (Li), iron (Fe), palladium (Pd), platinum (Pt), rubidium (Rb), chromium (Cr), and strontium (Sr).

The element which forms a solid solution with the conductive powder is capable of forming a solid solution with the conductive powder when present in the metallic glass.

When the metallic glass is heated to a temperature which is higher than a glass transition temperature (Tg) of the metallic glass, it may be soft, like glass, and show a liquid-like behavior. Herein, because the metallic glass includes an element which is capable of forming a solid solution with the conductive powder, the conductive powder may diffuse into the softened metallic glass.

For example, when the conductive paste including the metallic glass is disposed on a semiconductor substrate to form an electrode for a solar cell, the metallic glass becomes soft during the heat treatment. In addition, during the heat treatment, particles of the conductive powder form a solid solution with the element which forms a solid solution with the conductive powder when it is included in the metallic glass, and thus the particles of the conductive powder diffuse into the softened metallic glass.

Finally, the particles of the conductive powder may diffuse into the semiconductor substrate through the softened metallic glass when the element which forms a solid solution with the conductive powder is present. Accordingly, after cooling, crystallized particles of the conductive powder are produced at or near the surface of the semiconductor substrate in a large amount. In this way, the crystallized particles of the conductive powder formed at or near the surface of the semiconductor substrate may improve the transfer of charges produced in the semiconductor substrate by solar cell, thereby improving efficiency of the solar cell.

The element which is capable of forming a solid solution with a conductive powder may be selected from elements having a heat of mixing ("Hm") of less than 0 kiloJoules per mole (kJ/mol), specifically less than -0.1 kJ/mol, more specifically less than -0.5 kJ/mol with the conductive powder.

For example, when the conductive powder includes silver (Ag), the element which forms a solid solution with the conductive powder may include, for example, lanthanum (La), cerium (Ce), praseodymium (Pr), promethium (Pm), samarium (Sm), lutetium (Lu), yttrium (Y), neodymium (Nd), gadolinium (Gd), terbium (Tb), dysprosium (Dy), holmium (Ho), erbium (Er), thulium (Tm), thorium (Th), calcium (Ca), scandium (Sc), barium (Ba), ytterbium (Yb), strontium (Sr), europium (Eu), zirconium (Zr), lithium (Li), hafnium (Hf), magnesium (Mg), phosphorus (P), arsenic (As), palladium (Pd), gold (Au), plutonium (Pu), gallium(Ga), germanium (Ge), aluminum (Al), zinc (Zn), antimony (Sb), silicon (Si), tin (Sn), titanium (Ti), cadmium (Cd), indium(In), platinum (Pt), or mercury (Hg). The heat of mixing of representative combinations of an element which forms a solid solution with Ag are listed in the following Table 1.

**Table 1**

| X-Ag | Hm (kJ/mol) | X-Ag | Hm (kJ/mol) | X-Ag | Hm (kJ/mol) |
|---|---|---|---|---|---|
| La-Ag | -30 | Nd-Ag | -29 | Th-Ag | -29 |
| Ce-Ag | -30 | Gd-Ag | -29 | Ca-Ag | -28 |
| Pr-Ag | -30 | Tb-Ag | -29 | Sc-Ag | -28 |
| Pm-Ag | -30 | Dy-Ag | -29 | Ba-Ag | -28 |
| Sm-Ag | -30 | Ho-Ag | -29 | Yb-Ag | -28 |
| Lu-Ag | -30 | Er-Ag | -29 | Sr-Ag | -27 |
| Y-Ag | -29 | Tm-Ag | -29 | Eu-Ag | -27 |
| Zr-Ag | -20 | Au-Ag | -6 | Si-Ag | -3 |
| Li-Ag | -16 | Pu-Ag | -6 | Sn-Ag | -3 |
| Hf-Ag | -13 | Ga-Ag | -5 | Ti-Ag | -2 |
| Mg-Ag | -10 | Ge-Ag | -5 | Cd-Ag | -2 |
| P-Ag | -10 | Al-Ag | -4 | In-Ag | -2 |
| As-Ag | -8 | Zn-Ag | -4 | Pt-Ag | -1 |
| Pd-Ag | -7 | Sb-Ag | -4 | Hg-Ag | -1 |

For example, when the conductive powder includes aluminum (Al), the element which forms a solid solution with the conductive powder may include, for example, palladium (Pd), zirconium (Zr), platinum (Pt), thorium (Th), promethium (Pm), gadolinium (Gd), terbium (Tb), lutetium (Lu), hafnium (Hf), scandium (Sc), yttrium (Y), lanthanum (La), cerium (Ce), praseodymium (Pr), neodymium (Nd), samarium (Sm), dysprosium (Dy), holmium (Ho), erbium (Er), thulium (Tm), plutonium (Pu), rhodium (Rh), titanium (Ti), iridium (Ir), uranium (U), nickel (Ni), gold (Au), ruthenium (Ru), calcium (Ca), technetium (Tc), barium (Ba), ytterbium (Yb), manganese (Mn), cobalt (Co), europium (Eu), tantalum (Ta), strontium (Sr), niobium (Nb), osmium (Os), vanadium (V), phosphorus (P), iron (Fe), chromium (Cr), rhenium (Re), arsenic (As), molybdenum (Mo), lithium (Li), silver (Ag), magnesium (Mg), silicon (Si), germanium (Ge), tungsten (W), or copper (Cu). The heat of mixing of representative combinations of an element which forms a solid solution with Al are listed in the following Table 2.

**Table 2**

| X-Al | Hm (KJ/mol) | X-Al | Hm (KJ/mol) | X-Al | Hm (KJ/mol) |
|---|---|---|---|---|---|
| Pd-Al | -46 | Er-Al | -38 | Sr-Al | -18 |
| Zr-Al | -44 | Tm-Al | -38 | Nb-Al | -18 |
| Pt-Al | -44 | Pu-Al | -33 | Os-Al | -18 |
| Th-Al | -40 | Rh-Al | -32 | V-Al | -16 |
| Pm-Al | -39 | Ti-Al | -30 | P-Al | -12 |
| Gd-Al | -39 | Ir-Al | -30 | Fe-Al | -11 |
| Tb-Al | -39 | U-Al | -30 | Cr-Al | -10 |
| Lu-Al | -39 | Ni-Al | -22 | Re-Al | -9 |
| Hf-Al | -39 | Au-Al | -22 | As-Al | -6 |
| Sc-Al | -38 | Ru-Al | -21 | Mo-Al | -5 |
| Y-Al | -38 | Ca-Al | -20 | Li-Al | -4 |
| La-Al | -38 | Tc-Al | -20 | Ag-Al | -4 |
| Ce-Al | -38 | Ba-Al | -20 | Mg-Al | -2 |
| Pr-Al | -38 | Yb-Al | -20 | Si-Al | -2 |
| Nd-Al | -38 | Mn-Al | -19 | Ge-Al | -2 |
| Sm-Al | -38 | Co-Al | -19 | W-Al | -2 |
| Dy-Al | -38 | Eu-Al | -19 | Cu-Al | -1 |
| Ho-Al | -38 | Ta-Al | -19 | | |

For example, when the conductive powder includes copper (Cu), the element which forms a solid solution with the conductive powder may include, for example, thorium (Th), lutetium (Lu), scandium (Sc), zirconium (Zr), promethium (Pm), terbium (Tb), erbium (Er), thulium (Tm), gadolinium (Gd), yttrium (Y), praseodymium (Pr), neodymium (Nd), samarium (Sm), dysprosium (Dy), holmium (Ho), lanthanum (La), cerium (Ce), hafnium (Hf), palladium (Pd), calcium (Ca), platinum (Pt), ytterbium (Yb), europium (Eu), plutonium (Pu), titanium (Ti), gold (Au), barium (Ba), strontium (Sr), phosphorus (P), uranium (U), lithium (Li), arsenic (As), magnesium (Mg), rhodium (Rh), silicon (Si), or aluminum (Al). The heat of mixing of representative combinations of an element which forms a solid solution with Cu are listed in the following Table 3.

**Table 3**

| X-Cu | Hm (KJ/mol) | X-Cu | Hm (KJ/mol) | X-Cu | Hm (KJ/mol) |
|---|---|---|---|---|---|
| Th-Cu | -24 | Sm-Cu | -22 | Ti-Cu | -9 |
| Lu-Cu | -24 | Dy-Cu | -22 | Au-Cu | -9 |
| Sc-Cu | -24 | Ho-Cu | -22 | Ba-Cu | -9 |
| Zr-Cu | -23 | La-Cu | -21 | Sr-Cu | -9 |
| Pm-Cu | -23 | Ce-Cu | -21 | P-Cu | -9 |
| Tb-Cu | -23 | Hf-Cu | -17 | U-Cu | -7 |
| Er-Cu | -23 | Pd-Cu | -14 | Li-Cu | -5 |
| Tm-Cu | -23 | Ca-Cu | -13 | As-Cu | -3 |
| Gd-Cu | -22 | Pt-Cu | -12 | Mg-Cu | -3 |
| Y-Cu | -22 | Yb-Cu | -12 | Rh-Cu | -2 |
| Pr-Cu | -22 | Eu-Cu | -10 | Si-Cu | -2 |
| Nd-Cu | -22 | Pu-Cu | -9 | Al-Cu | -1 |

For example, when the conductive powder includes nickel (Ni), the element which forms a solid solution with the conductive powder may include, for example, strontium (Sr), rhodium (Rh), antimony (Sb), iron (Fe), iridium (Ir), europium (Eu), tungsten (W), beryllium (Be), magnesium (Mg), tin (Sn), platinum (Pt), calcium (Ca), chromium (Cr), molybdenum (Mo), ytterbium (Yb), manganese (Mn), boron (B), zinc (Zn), germanium (Ge), gallium (Ga), vanadium (V), silver (Ag), aluminum (Al), silicon (Si), plutonium (Pu), phosphorus (P), lanthanum (La), cerium (Ce), tantalum (Ta), uranium (U), niobium (Nb), praseodymium (Pr), neodymium (Nd), yttrium (Y), samarium (Sm), gadolinium (Gd), holmium (Ho), promethium (Pm), terbium (Tb), dysprosium (Dy), erbium (Er), thulium (Tm), thulium (Tm), lutetium (Lu), scandium (Sc), thorium (Th), hafnium (Hf), or zirconium (Zr). The heat of mixing of representative combinations of an element which forms a solid solution with Ni are listed in the following Table 4.

**Table 4**

| X-Ni | Hm (KJ/mol) | X-Ni | Hm (KJ/mol) |
|---|---|---|---|
| Sr-Ni | -1 | Pu-Ni | -25 |
| Rh-Ni | -1 | P-Ni | -26 |
| Sb-Ni | -1 | La-Ni | -27 |
| Fe-Ni | -2 | Ce-Ni | -28 |
| Ir-Ni | -2 | Ta-Ni | -29 |
| Eu-Ni | -3 | U-Ni | -29 |
| W-Ni | -3 | Nb-Ni | -30 |
| Be-Ni | -4 | Pr-Ni | -30 |
| Mg-Ni | -4 | Nd-Ni | -30 |
| Sn-Ni | -4 | Y-Ni | -31 |
| Pt-Ni | -5 | Sm-Ni | -31 |
| Ca-Ni | -7 | Gd-Ni | -31 |
| Cr-Ni | -7 | Ho-Ni | -31 |
| Mo-Ni | -7 | Pm-Ni | -32 |
| Yb-Ni | -7 | Tb-Ni | -32 |
| Mn-Ni | -8 | Dy-Ni | -32 |
| B-Ni | -9 | Er-Ni | -34 |
| Zn-Ni | -9 | Tm-Ni | -34 |
| Ge-Ni | -11 | Ti-Ni | -35 |
| Ga-Ni | -15 | Lu-Ni | -36 |
| V-Ni | -18 | Sc-Ni | -39 |
| As-Ni | -19 | Th-Ni | -39 |
| Al-Ni | -22 | Hf-Ni | -42 |
| Si-Ni | -23 | Zr-Ni | -49 |

The element which has a high oxidation potential and may be present in the metallic glass has a higher oxidation potential (e.g., standard free energy of formation of oxide) than any other components included in the metallic glass. Such characteristic may allow the element to be oxidized before the other components of the metallic glass, thereby preventing their oxidation. The element having a high oxidation potential may have a standard free energy of formation of oxide at least about 0.1 electron volt (eV), specifically at least about 0.3 eV, more specifically at least about 0.5 eV, or at least about 1 eV greater than a standard free energy of formation of oxide of each of the other components of the metallic glass.

When a conductive paste including the metallic glass is applied under the atmospheric environment during the preparation of electrode, it may be exposed to oxygen. If the element having a low resistivity is oxidized, a conductive paste may have sharply deteriorated conductivity. When the element which forms a solid solution with the conductive powder is oxidized, a conductive paste may have decreased solid solubility. Thus oxidation of any of the element having a low resistivity, or the element which forms a solid solution with the conductive powder is undesirable.

Accordingly, when a metallic glass includes the element having a high oxidation potential having a higher oxidation potential than each of the element having a low resistivity, and the element which forms a solid solution with the conductive powder, the element having a high oxidation potential is first oxidized and forms a stable oxide layer on the surface of the metallic glass. The oxide layer substantially or effectively prevents oxidation of other components, such as the element having a low resistivity, and the element which forms a solid solution with the conductive powder therein. Furthermore, degradation of the properties of the conductive paste due to other components in the metallic glass, such as oxides of the element having a low resistivity, or the element which forms a solid solution with the conductive powder, may be prevented.

The element having a high oxidation potential may have a larger absolute value of a Gibbs Free Energy of oxide formation (ΔG_{f}⁰) than an absolute value of a Gibbs Free Energy of oxide formation of each of the element having a low resistivity, and the element which forms a solid solution with the conductive powder. The larger the absolute value of the Gibbs free energy of oxide formation an element has, the easier it may be oxidized. The element having a high oxidation potential may have an absolute value of a Gibbs Free Energy of oxide formation of more than about 100 kJ/mol, specifically more than about 120 kJ/mol, more specifically more than about 140 kJ/mol. In an embodiment, the absolute value of the Gibbs Free Energy of oxide formation of the element having a high oxidation potential is about 100 to 2500 kJ/mol, specifically about 120 to about 2300 kJ/mol, more specifically about 140 to about 1900 kJ/mol.

The following Table 5 provides Gibbs free energy of oxide formation of representative elements.

**Table 5**

| Metal oxide | Δ_{f}G⁰ (kJ/mol) | Metal oxide | Δ_{f}G⁰ (kJ/mol) |
|---|---|---|---|
| Cu₂O | -146 | MoO₃ | -668 |
| Ti₂O | -147.3 | WO₃ | -764 |
| RuO₄ | -152.2 | Co₃O₄ | -774 |
| CdO | -228.7 | In₂O₃ | -830.7 |
| ZnO | -320.5 | SiO₂ | -856.3 |
| Rh₂O₃ | -343 | TiO₂ | -888.8 |
| K₂O₂ | -425.1 | Ga₂O₃ | -998.3 |
| Na₂O₂ | -447.7 | Fe₃O₄ | -1015.4 |
| Ni₂O₃ | -489.5 | ZrO₂ | -1042.8 |
| Bi₂O₃ | -493.7 | Cr₂O₃ | -1058.1 |
| SnO | -515.8 | B₂O₃ | -1194.3 |
| BaO | -520.3 | Mn₃O₄ | -1283.2 |
| GeO₂ | -521.4 | Al₂O₃ | -1582.3 |
| Li₂O | -561.2 | La₂O₃ | -1705.8 |
| SrO | -561.9 | Nd₂O₃ | -1720.8 |
| MgO | -569.3 | Nb₂O₅ | -1766 |
| BeO | -580.1 | V₃O₅ | -1803.3 |
| PbO | -601.2 | Y₂O₃ | -1816.6 |
| CaO | 603.3 | Sc₂O₃ | -1819.4 |
| | | Ti₃O₅ | -2317.4 |

The metallic glass may include an alloy of at least two elements of the element having a low resistivity, the element which forms a solid solution with the conductive powder, and the element having a high oxidation potential. Thus the at least two of the element having a low resistivity, the element which forms a solid solution with the conductive powder, and the element having a high oxidation potential that are included in the metallic glass is selected from the elements having a low resistivity, the elements which form a solid solution with the conductive powder, and the elements having a high oxidation potential. Accordingly, the metallic glass may have various combinations of the elements having a low resistivity, the elements which form a solid solution with the conductive powder, and the elements having a high oxidation potential. For example, when the elements having a low resistivity are 'A', 'A1', 'A2' et al., the elements which form a solid solution with the conductive powder are 'B', 'B1', 'B2' et al., and the elements having a high oxidation potential are 'C', 'C1', 'C2' et al., the combination may include alloys of various combinations of two components to six components et al. such as A-B, A-C, B-C, A-B-C, A-A1-B-B1, A-A1-B-B1-C, A-A1-B-B1-C-C1.

In an embodiment, the metallic glass includes two of the elements having a low resistivity, the elements which forms a solid solution with the conductive powder, and the elements having a high oxidation potential. In another embodiment, the metallic glass includes three of the elements having a low resistivity, the elements which forms a solid solution with the conductive powder, and the elements having a high oxidation potential. In another embodiment, the metallic glass includes each of the elements having a low resistivity, the elements which forms a solid solution with the conductive powder, and the elements having a high oxidation potential. In another embodiment, the metallic glass includes at least two of the elements having a low resistivity, and the elements which forms a solid solution with the conductive powder; the elements which forms a solid solution with the conductive powder, and the elements having a high oxidation potential; or elements having a low resistivity, the elements which forms a solid solution with the conductive powder, and the elements having a high oxidation potential. Also, in each embodiment, the elements having a low resistivity, the elements which forms a solid solution with the conductive powder, and the elements having a high oxidation potential may be the same or different. Also, a metal of the conductive powder may be the same or different than each of the elements having a low resistivity, the elements which forms a solid solution with the conductive powder, and the elements having a high oxidation potential.

Herein, the element having a low resistivity may be included to provide conductivity and may form an alloy with at least one selected from the element which forms a solid solution with the conductive powder, and the element having a high oxidation potential.

A supercooled liquid region of the metallic glass may range from about 5°C to about 200°C, specifically about 10°C to about 180°C, more specifically about 20°C to about 160°C, that is having a span of about 5°C to about 200°C, specifically about 10°C to about 180°C, more specifically about 20°C to about 160°C.

Also the supercooled liquid region may be within a temperature range of about 100°C to about 800°C, specifically about 150°C to about 750°C, more specifically about 200°C to about 700°C.

Herein, the supercooled liquid region of a metallic glass is a temperature region between a glass transition temperature ("T_{g}") and a crystallization temperature ("T_{c}") of the metallic glass. In the supercooled liquid region, the metallic glass has relatively low viscosity and shows a liquid-like behavior. The glass transition temperature may be about 50°C to about 700°C, specifically about 75°C to about 650°C, more specifically about 100°C to about 600°C. Also, the crystallization temperature may be about 60°C to about 720°C, specifically about 85°C to about 670°C, more specifically about 110°C to about 620°C.

In the supercooled liquid region, which is a temperature region between glass transition temperature (T_{g}) and crystallization temperature (T_{c}), the metallic glass shows a liquid-like behavior and can wet a lower layer (e.g., lower semiconductor layer) of a solar cell or other electronic device, e.g., semiconductor substrate. Herein, when the supercooled liquid region is large, the conductive paste may improve wetting properties towards a substrate, such as a semiconductor substrate.

For example, when a conductive paste including the metallic glass is applied on a semiconductor substrate to fabricate an electrode for a solar cell, the larger the supercooled liquid region of the softened metallic glass on the semiconductor substrate, the better the conductive paste wets the semiconductor substrate. The improved wetting properties of the conductive paste may allow the conductive powder, which diffuses into the softened metallic glass, to permeate into a larger area of the semiconductor substrate. Accordingly, the electrode disposed on the semiconductor substrate may have better contact (e.g., electrical contact) with the semiconductor substrate, thereby improving adherence therebetween and providing a larger or improved conductive path through which charges produced in the semiconductor substrate by solar light may transport. As a result, the electrode may improve efficiency of a solar cell.

The following Table 6 shows that when a metallic glass including copper (Cu) and zirconium (Zr), and further including aluminum (Al), silver (Ag), nickel (Ni), titanium (Ti), iron (Fe), palladium (Pd) and/or hafnium (Hf), the metallic glass has a large supercooled liquid region.

At least one selected from aluminum (Al), silver (Ag), nickel (Ni), titanium (Ti), iron (Fe), palladium (Pd) and hafnium (Hf) may be included in an amount of about 10 atomic percent (at%) or less, specifically about 5 at% or less, more specifically about 0.1 to about 10 at%, or about 1 to about 8 at%, based on a total amount of the metallic glass. When it is included within the foregoing range, a metallic glass may include the other components in a sufficient amount. Accordingly, the metallic glass may have sufficient conductivity and oxidation resistance as the metallic glass may have a large supercooled liquid region as well as improved solid solubility with the conductive powder.

As described above, the supercooled liquid region of a metallic glass is a temperature region between a glass transition temperature ("T_{g}") and a crystallization temperature ("T_{c}") of the metallic glass. Thus, the supercooled liquid region of a metallic glass can be characterized as the difference between T_{c} and T_{g}.

**Table 6**

| | Glass transition temperature (Tg, K) | Crystallization temperature (Tc,K) | Supercooled liquid region (ΔTx,K) |
|---|---|---|---|
| Cu₅₀Zr₅₀ | 675 | 724 | 49 |
| Cu₅₄Zr₂₂Ni₆Ti₁₈ | 712 | 769 | 57 |
| Cu₄₈Zr₄₈Al₄ | 688 | 756 | 68 |
| Cu₄₇Zr₄₇Al₆ | 691 | 770 | 79 |
| Cu₅₀Zr₄₃Al₇ | 731 | 792 | 61 |
| Cu₄₆Zr₄₆Al₈ | 696 | 789 | 93 |
| Cu₄₅Zr₄₅Al₁₀ | 710 | 787 | 77 |
| Cu₄₅Zr₄₅Ag₁₀ | 683 | 756 | 73 |
| Cu₄₈Zr₄₈Al₂Ag₂ | 677 | 742 | 65 |
| Cu₄₆Zr₄₆Al₄Ag₄ | 686 | 767 | 81 |
| Cu₄₇Zr₄₅Al₄Ag₄ | 688 | 770 | 82 |
| Cu₄₈Zr₄₄Al₄Ag₄ | 692 | 779 | 87 |
| Cu₄₉Zr₄₃Al₄Ag₄ | 694 | 780 | 86 |
| Cu₅₀Zr₄₂Al₄Ag₄ | 703 | 784 | 81 |
| Cu₄₅Zr₄₅Al₅Ag₅ | 697 | 783 | 86 |
| Cu₄₄Zr₄₄Al₆Ag₆ | 698 | 790 | 92 |
| Cu₃₀Zr₄₈Al₈Ag₈Ni₆ | 688 | 779 | 91 |
| Cu₃₄Zr₄₈Al₈Ag₈Ni₂ | 683 | 799 | 116 |
| Cu₂₆Zr₄₈Al₈Ag₈Ni₁₀ | 692 | 768 | 76 |
| Cu_{22.8}Zr_{61.4}Al_{9.9}Ag₁Fe_{4.95} | 656 | 753 | 97 |
| Cu₃₄Zr₄₈Al₈Ag₈Fe₂ | 705 | 806 | 101 |
| Cu₃₆Zr₄₆Al₈Ag₈Hf₂ | 692 | 794 | 102 |
| Cu₃₆Zr₄₂Al₈Ag₈Hf₆ | 695 | 796 | 101 |
| Cu₃₄Zr₄₈Al₈Ag₈Pd₂ | 699 | 794 | 95 |
| Cu₃₀Zr₄₈Al₈Ag₈Pd₆ | 709 | 796 | 87 |

The metallic glass may be at least one selected from, for example, Cu₅₄Zr₂₂Ni₆Ti_{18,□} Cu₄₈Zr₄₈Al₄,□ Cu₄₅Zr₄₅Agᵢ₁,□ Cu₄₇Zr₄₅Al₄Ag₄,□ Cu₄₃Zr₄₃Al₇Ag₇, Cu₃₀Zr₄₈Al₈Ag₈Ni₆,□ Cu_{22.8}Zr_{61.4}Al_{9.9}Ag₁Fe_{4.95},□ Cu₃₆Zr₄₆Al₈Ag₈Hf₂,□ Cu₃₀Ag₃₀Zr₃₀Ti₁₀, Mg₆₅Cu₁₅Ag₁₀Gd₁₀, Mg₆₅Cu₁₅Ag₁₀Gd₁₀, Mg₆₅Cu₂₅Gd₁₀, Mg₆₅Cu₂₀Ag₅Y₁₀, Mg₆₅Cu₂₅Y₁₀, Mg₆₅Cu₁₅Ag₁₀Y₁₀, Cu₄₆Gd₄₇Al₇, Ca₆₀Mg₂₅Ni₁₅, Mg₆₅Cu₁₅Ag₅Pd₅Gd₁₀, Mg₇₀Ni₁₀Gd₂₀, Cu₄₆Y_{42.5}Al₇, Ti₅₅Zr₁₈Be₁₄Cu₇Ni₆, Ti₅₁Y₄Zr₁₈Be₁₄Cu₇Ni₆, Ti₄ₒZr₂₈Cu₉Ni₇Be₁₆, Ti₄₀Zr₂₅Ni₈Cu₉Be₁₈, Ti₄₉Nb₆Zr₁₈Be₁₄Cu₇Ni₆, Ti₅₀Zr₁₅Be₁₈Cu₉Ni₈, Ti₃₄Zr₃₁Cu₁₀Ni₈Be₁₇, Zr₃₆Ti₂₄Be₄₀, Ti₆₅Be₁₈Cu₉Ni₈, Zr₆₅Al_{7.5}Cu₁₇.₅Ni₁₀, Zr₆₅Al_{7.5}Cu_{12.6}Ni₁₀Ag₅, Cu₅₀Zr₄₀Ti₁₀, Cu₃₀Ag₃₀Zr₃₀Ti₁₀, Ni₅₅Zr₁₂Al₁₁Y₂₂, and Cu₄₀Ni₅Ag₁₅Zr₃₀Ti₁₀, but is not limited thereto.

The organic vehicle may include an organic compound, an optional organic solvent, and optional additives known for use in the manufacture of conductive pastes for solar cells. The organic vehicle is combined with the conductive powder and the metallic glass primarily to provide a viscosity and rheology to the conductive paste effective for printing or coating the conductive paste. A wide variety of inert organic materials can be used, and can be selected by one of ordinary skill in the art without undue experimentation to achieve the desired viscosity and rheology, as well as other properties such as dispersibility of the conductive powder and the metallic glass, stability of conductive powder and the metallic glass and any dispersion thereof, drying rate, firing properties, and the like. Similarly, the relative amounts of the organic compound, any optional organic solvent, and any optional additive can be adjusted by one of ordinary skill in the art without undue experimentation in order to achieve the desired properties of the conductive paste.

The organic compound may be a polymer, for example, at least one selected from a C1 to C4 alkyl (meth)acrylate-based resin; a cellulose such as ethyl cellulose or hydroxyethyl cellulose; a phenolic resin; wood rosin; an alcohol resin; a halogenated polyolefin such as tetrafluoroethylene (e.g., TEFLON); and the monobutyl ether of ethylene glycol monoacetate.

The organic vehicle may further optionally include at least one additive selected from, for example, a surfactant, a thickener, and a stabilizer.

The solvent may be any solvent capable of dissolving or suspending the above other components of the conductive paste and may be, for example, at least one selected from terpineol, butylcarbitol, butylcarbitol acetate, pentanediol, dipentyne, limonene, an ethyleneglycol alkylether, a diethyleneglycol alkylether, an ethyleneglycol alkylether acetate, a diethyleneglycol alkylether acetate, a diethyleneglycol dialkylether acetate, a triethyleneglycol alkylether acetate, a triethylene glycol alkylether, a propyleneglycol alkylether, propyleneglycol phenylether, a dipropyleneglycol alkylether, a tripropyleneglycol alkylether, a propyleneglycol alkylether acetate, a dipropyleneglycol alkylether acetate, a tripropyleneglycol alkyl ether acetate, dimethylphthalic acid, diethylphthalic acid, dibutylphthalic acid, and desalted water.

The conductive powder, the metallic glass, and the organic vehicle may be included in an amount of about 30 to about 99 weight percent (wt%), about 0.1 to about 20 wt%, and about 0.9 to about 69.9 wt%, specifically about 40 to about 98 wt%, about 1 to about 20 wt%, and about 1 to about 59 wt%, more specifically about 40 to about 95 wt%, about 2 to about 20 wt%, and about 3 to about 58 wt%, further specifically about 50 to about 90 wt%, about 4 to about 20 wt%, and about 6 to about 46 wt%, respectively, based on the total weight of the conductive paste.

The conductive paste is prepared by combining the components of the conductive paste by, for example, mechanical mixing. The conductive paste may be screen-printed to provide an electrode for an electronic device.

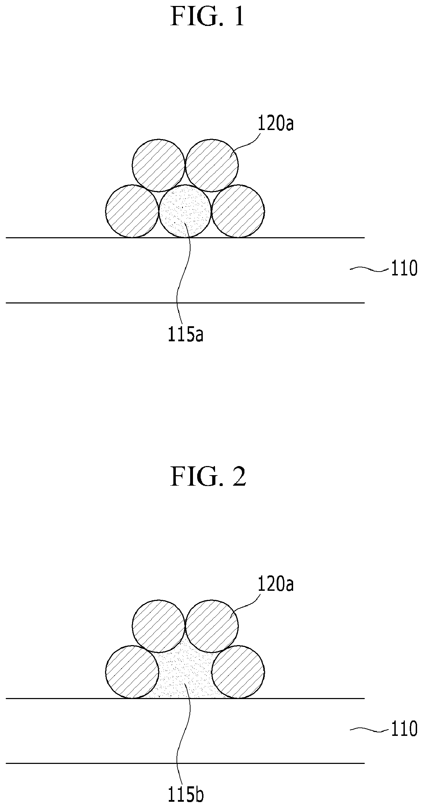

Hereinafter, illustrated is an electrode fabricated using the aforementioned conductive paste referring to FIGS. 1 to 4C.

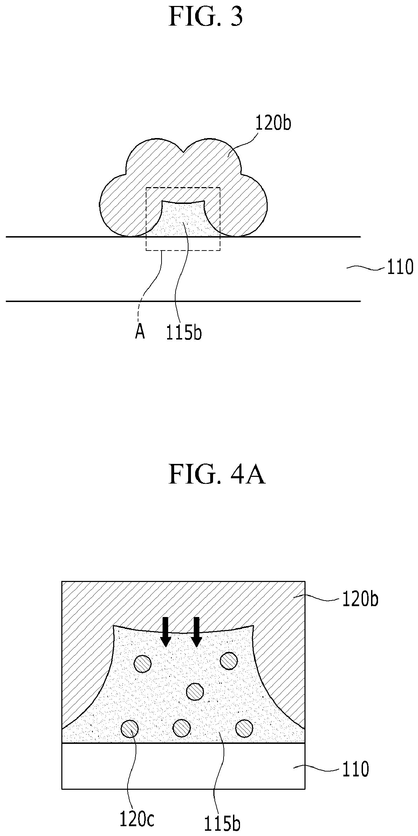

FIGS. 1 to 3 are a schematic diagram showing that when a conductive paste according to an embodiment is applied on a semiconductor substrate, a conductive powder and a metallic glass included therein are transformed due to heat and contact with the semiconductor substrate. FIGS. 4A to 4C are a schematic diagram enlarging region A of FIG. 3.

Referring to FIG. 1, a conductive paste including a conductive powder 120a and a metallic glass 115a is applied on a semiconductor substrate 110. The conductive powder 120a and the metallic glass 115a may each have the form of a particle having a spherical shape, for example.

Referring to FIG. 2, when the metallic glass 115a is heated to a first temperature higher than its glass transition temperature ("T_{g}"), the metallic glass 115a becomes soft and turns into a liquid-like metallic glass 115b. The first temperature may be about 1 to about 300°C, specifically about 5 to about 250°C, more specifically about 10 to about 200°C higher than the T_{g} of the metallic glass. The liquid-like metallic glass 115b, which has liquid-like properties, may fill a gap among a plurality of particles of the conductive powder 120a. Herein, the metallic glass 115a is first softened, because the glass transition temperature ("T_{g}") of the metallic glass 115a is lower than the sintering temperature ("Tₛ") of the conductive powder 120a.

Referring to FIG. 3, when a conductive paste is heated to a second temperature higher than the sintering temperature, the conductive powder 120a is sintered and particles of the conductive powder 120a closely bond with neighboring particles of conductive powder 120a to form a conductive powder agglomerate 120b. The second temperature may be about 1 to about 300°C, specifically about 5 to about 250°C, more specifically about 10 to about 200°C higher than the Tₛ of the metallic glass.

As shown in FIGS. 2 and 3, the liquid-like metallic glass, which has liquid-like properties, is a supercooled liquid and wets a semiconductor substrate 110.

Referring to FIG. 4A, when the liquid-like metallic glass 115b is a supercooled liquid, some conductive particles 120c of the conductive powder agglomerate 120b diffuse into the liquid-like metallic glass 115b. As aforementioned, the liquid-like metallic glass 115b includes a component which can form a solid solution with the conductive powder agglomerate 120b.

In addition, as aforementioned, when a metallic glass has a large supercooled liquid region, the liquid-like metallic glass 115b has a low viscosity and remains on and wets the semiconductor substrate 110. Accordingly, contact between the liquid-like metallic glass 115b and the semiconductor substrate 110 is improved.

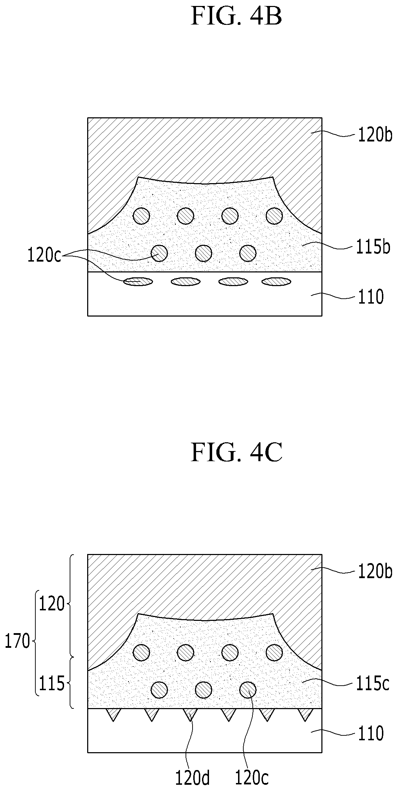

Referring to FIG. 4B, when heated to a third temperature higher than the second temperature, conductive particles 120c diffuse into the liquid-like metallic glass 115b and permeate into the semiconductor substrate 110. The third temperature may be about 1 to about 300°C, specifically about 5 to about 250°C, more specifically about 10 to about 200°C higher than the second temperature. Herein, as aforementioned, the liquid-like metallic glass 115b may have improved wetting properties and provide improved contact with the semiconductor substrate 110. Accordingly, the metallic glass may have a larger area in which conductive particles 120c permeate into the semiconductor substrate 110.

Referring to FIG. 4C, when the semiconductor substrate 110 is cooled down, conductive particles 120c permeated into the semiconductor substrate 110 crystallize to form crystallized conductive particles 120d at the surface of the semiconductor substrate 110. Also, the liquid-like metallic glass 115b may also crystallize to form a crystalline metallic glass 115c and the conductive particles 120c in the metallic glass may also crystallize.

In this way, an electrode 170 including the conductive powder agglomerate 120b may be formed.

The electrode 170 may include a buffer layer 115 including a crystalline metallic glass 115c and positioned at a region which is adjacent to the semiconductor substrate 110, and an electrode portion 120 positioned at a region except the buffer layer and including a conductive material.

FIG. 4C shows that the buffer layer 115 is formed, but is not limited thereto. The buffer layer 115 may be omitted, or may be formed on a part of a region which is adjacent to the semiconductor substrate 110.

The crystallized conductive particles 120d in the buffer layer 115 and at the surface of the semiconductor substrate 110 effectively improve transfer of charges produced by solar light in the semiconductor substrate 110 to the electrode portion 120 and, simultaneously, decrease a contact resistance between the semiconductor substrate 110 and the electrode portion 120, thereby decreasing charge loss of a solar cell. Ultimately, the solar cell may have improved efficiency.

The electrode may be used as a conductive electrode for various other electronic devices.

The electrode may have a contact resistance of about 1 kΩcm² or less, specifically about 1 µΩcm² to about 10 Ωcm². When it is included within the foregoing range, the electrode may effectively decrease loss of electric power, and an electronic device, for example, a solar cell may have improved efficiency.

The electrode may have a resistivity of about 10 mΩcm or less, specifically about 1 µΩcm to about 100 µΩcm. When it is included within the foregoing range, the electrode may effectively decrease loss of electric power, and an electronic device, for example, a solar cell may have improved efficiency.

A representative electronic device is a solar cell.

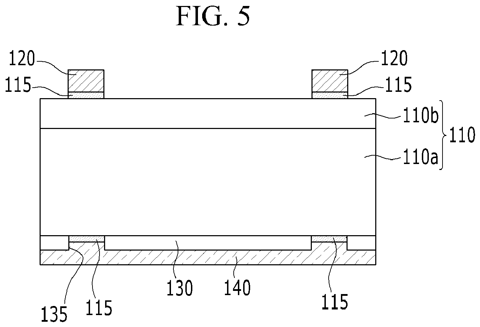

Referring to FIG. 5, a solar cell according to an embodiment is disclosed in further detail.

FIG. 5 is a cross-sectional view showing a solar cell according to an embodiment.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

Hereinafter, positions of (or spatial relationships between) components will be described with respect to a semiconductor substrate 110 for better understanding and ease of description, but the disclosed embodiment is not limited thereto. In addition, for clarity of description, a solar energy incident side of a semiconductor substrate 110 is called a front side, and the opposite side is called a rear side, although alternative configurations are possible.

Referring to FIG. 5, a solar cell according to an embodiment may include a semiconductor substrate 110 including a lower semiconductor layer 110a and an upper semiconductor layer 110b.

The semiconductor substrate 110 may comprise a crystalline silicon or a compound semiconductor. The crystalline silicon may be, for example, a silicon wafer. One of the lower semiconductor layer 110a and the upper semiconductor layer 110b may be a semiconductor layer doped with a p-type impurity, and the other may be a semiconductor layer doped with an n-type impurity. For example, the lower semiconductor layer 110a may be a semiconductor layer doped with a p-type impurity, and the upper semiconductor layer 110b may be a semiconductor layer doped with an n-type impurity. Herein, the p-type impurity may be a Group III element such as boron (B), and the n-type impurity may be a Group V element such as phosphorus (P).

The surface of the upper semiconductor layer 110b may be textured, for example by surface texturing. The surface-textured upper semiconductor layer 110b may have protrusions and depressions, and may comprise a pyramidal shape, or may have a porous structure having a honeycomb shape, for example. The surface-textured upper semiconductor layer 110b may have an enhanced surface area to improve the light-absorption rate and decrease reflectivity, thereby improving efficiency of a solar cell.

A front electrode is disposed (e.g., formed) on the upper semiconductor layer 110b. The front electrode may be arranged in parallel to a direction of the substrate, and may have a grid pattern shape to reduce shadowing loss and sheet resistance.

The front electrode may include a buffer layer 115 including a crystalline metallic glass 115c and positioned at a region which is adjacent to the upper semiconductor layer 110b, and a front electrode portion 120 positioned at a region except the buffer layer 115 and including a conductive material.

The front electrode may be disposed by a screen printing a conductive paste. The conductive paste is the same as described above.

The front electrode portion 120 may include a conductive material, for example, a low resistivity conductive material such as silver (Ag).

A buffer layer 115 is disposed between the upper semiconductor layer 110b and the front electrode portion 120 by heat treating the conductive paste disposed to form the front electrode. The buffer layer 115 may be conductive due to inclusion of the metallic glass. Because the buffer layer 115 has portions that are adjacent to the electrode portion 120 and the upper semiconductor layer 110b, it may decrease loss of electric charges by enlarging the effective path for transferring electric charges between the upper semiconductor layer 110b and the front electrode portion 120. The buffer layer may also reduce resistive losses, for example.

The metallic glass of the buffer layer 115 is derived from the conductive paste used to form the front electrode. The metallic glass may melt before the conductive material of the front electrode portion 120 during processing, so that the metallic glass is disposed under the front electrode portion 120 to form the buffer layer.

FIG. 5 shows that the buffer layer 115 is formed, but is not limited thereto. The buffer layer 115 may be omitted, or may be formed on a part of a region which is adjacent to the upper semiconductor layer 110b.

A bus bar electrode (not shown) may be disposed on the front electrode portion 120. The bus bar electrode can connect adjacent solar cells of a plurality of solar cells.

A dielectric layer 130 may be formed under the semiconductor substrate 110. The dielectric layer 130 may increase efficiency of a solar cell by substantially or effectively preventing recombination of electric charges and leaking of electric current. The dielectric layer 130 may include a penetration part 135 (e.g., a through hole), and the semiconductor substrate 110 and a rear electrode 140 that will be further described below may contact through the penetration part 135.

The dielectric layer 130 may include at least one selected from silicon oxide (SiO₂), silicon nitride (SiNₓ), aluminum oxide (Al₂O₃, and may have a thickness of about 100 to about 2000 angstroms (Å), specifically about 200 to about 1800 Å, more specifically about 300 to about 1600 Å.

A rear electrode is disposed under the dielectric layer 130. The rear electrode may include a conductive material, and the conductive material may be an opaque metal such as aluminum (Al). The rear electrode may be disposed by screen printing a conductive paste in the same manner as the front electrode.

The rear electrode may include a buffer layer 115 positioned at a region which is adjacent to a lower semiconductor layer 110a, and a rear electrode portion 140 positioned at a region except the buffer layer and including a conductive material in the same manner as the front electrode.

Hereinafter, a method of manufacturing the solar cell is further described with reference to FIG. 5.

First, a semiconductor substrate 110, such as a silicon wafer, is prepared. The semiconductor substrate 110 may be doped with an impurity, such as a p-type impurity, as an example.

Then the semiconductor substrate 110 may be subjected to a surface texturing treatment. The surface-texturing treatment may be performed by a wet method using at least one strong acid selected from, for example, nitric acid, hydrofluoric acid, and the like, or at least one strong base selected from, for example, sodium hydroxide and the like; or the surface-texturing treatment may be performed by a dry method such as plasma treatment.

Then, the semiconductor substrate 110 may be doped with an n-type impurity, for example. The n-type impurity may be doped by diffusing at least one selected from, for example, POCl₃, H₃PO₄, and the like at a high temperature. The semiconductor substrate 110 includes a lower semiconductor layer 110a and an upper semiconductor layer 110b doped with different impurities than each other.

Then a conductive paste for a front electrode is applied on the upper semiconductor layer 110b. The conductive paste for a front electrode may be applied by a screen printing method. The screen printing method includes applying the conductive paste, which comprises a conductive powder, a metallic glass, and an organic vehicle at a location where a front electrode is disposed, and drying the same.

As further disclosed above, the conductive paste may include a metallic glass, and the metallic glass may be prepared using any suitable method such as melt spinning, infiltration casting, gas atomization, ion irradiation, or mechanical alloying.

Then the conductive paste for a front electrode may be dried.

A dielectric layer 130 may be provided by disposing (e.g., stacking, forming, or depositing) aluminum oxide (Al₂O₃) or silicon oxide (SiO₂) on an entirety of or on a portion of a rear side of the semiconductor substrate 110. The dielectric layer 130 may be disposed by a plasma enhanced chemical vapor deposition ("PECVD") method, for example.

Then a penetration part 135 may be provided on a portion of the dielectric layer 130 by ablation with a laser, for example.

The conductive paste for a rear electrode is subsequently applied on a side of the dielectric layer 130, which in an embodiment is opposite the semiconductor substrate 110, by a screen printing method.

Then, a conductive paste for a rear electrode is dried.

Next, the conductive paste for a front electrode and the conductive paste for a rear electrode are co-fired (e.g., heat treated), or fired individually. Thus the conductive paste for a front electrode and the conductive paste for a rear electrode may be fired in the same or in different processes.

The firing may be performed in a furnace and at a temperature higher than the melting temperature of the conductive metal, for example at a temperature ranging from about 400°C to about 1000°C, specifically about 450°C to about 950°C, more specifically about 500°C to about 900°C.

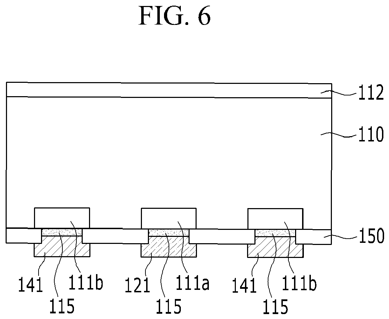

Hereinafter, a solar cell according to another embodiment is disclosed referring to FIG. 6.

FIG. 6 is a cross-sectional view showing a solar cell according to another embodiment.

A solar cell may include a semiconductor substrate 110 doped with a p-type or an n-type impurity. The semiconductor substrate 110 may include a first doping region 111a and second doping region 111b that are provided on the rear side of the semiconductor substrate 110, and are doped with different impurities than each other. For example, the first doping region 111a may be doped with an n-type impurity, and the second doping region 111b may be doped with a p-type impurity. The first doping region 111a and the second doping region 111b may be alternately disposed on the rear side of the semiconductor substrate 110.

The front side of the semiconductor substrate 110 may be surface-textured, and therefore may enhance the light-absorption rate and decrease the reflectivity of the solar cell, thereby improving efficiency of the solar cell. An insulation layer 112 is provided on the semiconductor substrate 110. The insulation layer 112 may comprise an insulating material that is substantially transparent and thus absorbs little light, for example at least one selected from silicon nitride (SiNₓ), silicon oxide (Si0₂), titanium oxide (TiO₂), aluminum oxide (Al₂O₃), magnesium oxide (MgO), and cerium oxide (CeO₂). The insulation layer 112 may be a single layer or more than one layer. The insulation layer 112 may have a thickness ranging from about 200 to about 1500 Å, specifically 300 to about 1400 Å, more specifically about 400 to about 1300 Å.

The insulation layer 112 may be an anti-reflective coating ("ARC") that decreases the reflectivity of light and increases selectivity of a particular wavelength region on the surface of the solar cell, and simultaneously improves properties of silicon on the surface of the semiconductor substrate 110, thereby increasing efficiency of the solar cell.

A dielectric layer 150 including first and second penetration parts may be disposed on the rear side of the semiconductor substrate 110.

The first electrode electrically connected with the first doping region 111a and the second electrode electrically connected with the second doping region 111b are disposed on the rear side of the semiconductor substrate 110, respectively. The first electrode and the first doping region 111a may be contacted through the first penetration part, and the second electrode and the second doping region 111b may be in contact through the second penetration part. The first electrode and the second electrode may be alternately disposed.

The first electrode may include a buffer layer 115 positioned at a region which is adjacent to the first doping region 111a, and a first electrode portion 121 positioned at a region except the buffer layer 115. The second electrode may include a buffer layer 115 positioned at a region which is adjacent to the second doping region 111b, and a second electrode portion 141 positioned at a region except the buffer layer 115.

As disclosed in the above embodiment, the front electrode and the rear electrode may be disposed using a conductive paste including a conductive powder, a metallic glass, and an organic vehicle, which is the same as described above.

A buffer layer 115 is disposed between the first doping region 111a and the first electrode portion 121, or between the second doping region 111b and the second electrode portion 141. The buffer layer 115 may be electrically conductive due inclusion of a metallic glass. Because the buffer layer 115 includes portions which are adjacent to either the first electrode portion 121 or the second electrode portion 141, and portions which are adjacent to either the first doping region 111a or the second doping region 111b, respectively, loss of electric charge may be decreased by enlarging or otherwise improving the path for transferring electric charge between the first doping region 111a and the first electrode portion 121, or between the second doping region 111b and the second electrode portion 141. In addition, the buffer layer 115 may substantially or effectively prevent a material of the first electrode portion 121 or the second electrode portion 141 from diffusing into the first or second doping regions 111a or 111b, respectively.

FIG. 6 shows that the buffer layer 115 is formed, but is not limited thereto. The buffer layer 115 may be omitted, or may be formed on a part of a region which is adjacent to the first doping region 111a, a part of a region which is adjacent to the second doping region 111b, or a combination thereof.

A solar cell according to the embodiment including both of the first electrode and the second electrode on the rear surface of the solar cell may decrease an area where a metal is disposed on the front surface. This may decrease shadowing loss and increase solar cell efficiency.

Hereinafter, the method of manufacturing a solar cell will be further disclosed referring to FIG. 6.

First, a semiconductor substrate 110 doped with, for example, an n-type impurity is prepared. Then, the semiconductor substrate 110 is surface-textured, and insulation layer 112 and dielectric layer 150 are disposed on a front side and a rear side of the semiconductor substrate 110, respectively. The insulation layer 112 and the dielectric layer 150 may be provided by chemical vapor deposition ("CVD"), for example.

Then, the first doping region 111a and the second doping region 111b may be disposed by sequentially doping a p-type impurity and an n-type impurity at a high concentration in the rear side of the semiconductor substrate 110.

Then, a conductive paste for a first electrode is applied on a portion (e.g. on a side) of the dielectric layer 150 corresponding to the first doping region 111a, and a conductive paste for a second electrode is applied a portion of the dielectric layer 150 corresponding to the second doping region 111b. The conductive paste for the first electrode and the conductive paste for the second electrode may be disposed by screen printing, for example, and the conductive paste may include the conductive powder, the metallic glass, and the organic vehicle.

Next, the conductive paste for the first electrode and the conductive paste for the second electrode may be fired together or separately. The firing (e.g., heat treating) may be performed in a furnace at a temperature higher than the melting temperature of a conductive metal.

Herein, the conductive paste is applied to provide an electrode for a solar cell, but the conductive paste may also be used to provide an electrode for various other electronic devices such as a plasma display panel ("PDP"), a liquid crystal display ("LCD"), or an organic light emitting diode ("OLED").

The following examples illustrate this disclosure in more detail. However, it is understood that this disclosure is not limited by these examples.

In the following examples Examples 1 and 2 do not fall within the scope of claim 1 and are provided for reference purposes only.

### Preparing Conductive Paste and Electrode

### Example 1

Silver (Ag) powder and metallic glass of Cu₅₀Zr₅₀ are added into an organic vehicle including an ethyl cellulose binder and a butyl carbitol solvent. The silver (Ag) powder, the metallic glass of Cu₅₀Zr₅₀, and the organic vehicle are mixed at about 84 wt%, about 4 wt%, and about 12 wt%, respectively, based on the total amount of conductive paste.

It is kneaded using a 3-roll mill to provide a conductive paste.

The conductive paste is coated on a silicon wafer by a screen printing method. Then it is rapidly heated to about 500°C using a belt furnace, and slowly heated to about 900°C. It is cooled to provide an electrode.

### Example 2

A conductive paste is prepared in accordance with the same procedure as in Example 1 to provide an electrode, except that Cu₄₃Zr₄₃Al₇Ag₇ is used as a metallic glass instead of Cu₅₀Zr₅₀.

### Assessment - 1

Each contact resistance and resistivity of electrodes obtained from Examples 1 and 2 is determined. The contact resistance and the resistivity are determined by a transfer length method (TLM).

Table 7 shows the contact resistance and the resistivity of each electrode obtained from Examples 1 and 2.

**Table 7**

| | Contact resistance (mΩcm²) | Resistivity (µΩcm) |
|---|---|---|
| Example 1 | 60.57 | 3.2 |
| Example 2 | 39 | 2.87 |

As shown in Table 7, it can be observed that the electrodes obtained in Examples 1 and 2 have low contact resistance and resistivity.

Additionally, the electrode obtained in Example 2 has lower contact resistance and resistivity than the electrode obtained in Example 1, because the metallic glass used in the electrode of Example 2 includes silver (Ag) as well as aluminum (Al) capable of providing a solid-solution with silver (Ag).

## Claims

1. A conductive paste comprising:
a conductive powder,
a metallic glass, and
an organic vehicle,
wherein the metallic glass comprises an alloy of at least two elements selected from
an element having a low resistivity,
an element which forms a solid solution with the conductive powder,
an element having a high oxidation potential,
wherein the element having a low resistivity has a resistivity of less than about 100 microohm-centimeters, and
the element having a high oxidation potential has an absolute value of a Gibbs free energy of oxide formation of about 100 kiloJoules per mole or greater,
wherein the metallic glass is not Cu₅₀Zr₅₀, CU₃₀Ag₃₀Zr₃₀Ti₁₀, Cu₄₃Zr₄₃Al₇Ag₇, Cu₄₆Zr₄₆Al₈, Cu_{58.1}Zr_{35.9}Al₆, Ti₅₀Ni₁₅Cu₃₂Sn₃, Ti₄₅Ni₁₅Cu₂₅Sn₃Be₇Zr₅, Ni₆₀Nb₃₀Ta₁₀, Ni₆₁Zr₂₀Nb₇Al₄Ta₈, Ni_{57.5}Zr₃₅Al_{7.5}, Zr_{41.2}Ti_{13.8}Ni₁₀Cu_{12.5}Be_{22.5}, Mg₆₅Y₁₀Cu₁₅Ag₅Pd₅, Mn₅₅Al₂₅Ni₂₀, La₅₅Al₂₅Ni₁₀Cu₁₀,
Mg₆₅Cu_{7.5}Ni_{7.5}Ag₅Zn₅Gd₁₀, Mg₆₅Cu₁₅Ag₁₀Y₆Gd₄,
Fe₇₇Nb₆B₁₇, Fe₆₇Mo₁₃B₁₇Y₃, Ca₆₅Mg₁₅Zn₂₀, or Ca_{66.4}Al_{33.6}.

2. The conductive paste of claim 1, wherein the conductive powder comprises a silver, an aluminum, a copper, a nickel or a combination thereof.

3. The conductive paste of claim 1 or 2, wherein the conductive powder has a size range from 1 nm to 50 µm.

4. The conductive paste of any of claims 1-3, wherein the element having the low resistivity has a resistivity of less than 15 microohm-centimeters.

5. The conductive paste of any of claims 1-4, wherein the element having the low resistivity comprises at least one selected from silver, copper, gold, aluminum, calcium, beryllium, magnesium, sodium, molybdenum, tungsten, tin, zinc, nickel, potassium, lithium, iron, palladium, platinum, rubidium, chromium, and strontium.

6. The conductive paste of any of claims 1-5, wherein the element which forms the solid solution with the conductive powder has a heat of mixing with the conductive powder of less than 0 KJ/mol.

7. The conductive paste of claim 6, wherein the element which forms the solid solution with the conductive powder comprises at least one selected from lanthanum, cerium, praseodymium, promethium, samarium, lutetium, yttrium, neodymium, gadolinium, terbium, dysprosium, holmium, erbium, thulium, thorium, calcium, scandium, barium, ytterbium, strontium, europium, zirconium, lithium, hafnium, magnesium, phosphorus, arsenic, palladium, gold, plutonium, gallium, germanium, aluminum, zinc, antimony, silicon, tin, titanium, cadmium, indium, platinum, rhodium, iridium, uranium, nickel, ruthenium, technetium, manganese, cobalt, tantalum, niobium, osmium, vanadium, iron, chromium, rhenium, molybdenum, silver, tungsten, beryllium, boron, copper, and mercury.

8. The conductive paste of any of claims 1-7, wherein the element having the high oxidation potential comprises at least one selected from copper, titanium, ruthenium, cadmium, zinc, rhodium, potassium, sodium, nickel, bismuth, tin, barium, germanium, lithium, strontium, magnesium, beryllium, lead, calcium, molybdenum, tungsten, cobalt, indium, silicon, gallium, iron, zirconium, chromium, boron, manganese, aluminum, lanthanum, neodymium, niobium, vanadium, yttrium, and scandium.

9. The conductive paste of any of claims 1-8, wherein the conductive powder, the metallic glass, and the organic vehicle are included in an amount of 30 to 99 weight percent, 0.1 to 20 weight percent, and 0.9 to 69.9 weight percent based on a total weight of the conductive paste.

10. The conductive paste of any of claims 1-9, wherein the metallic glass is substantially amorphous.

11. The conductive paste of any of claims 1-10, wherein the metallic glass has a supercooled liquid region of 5°C to 200°C.

12. The conductive paste of any of claims 1-11, wherein the metallic glass comprises copper and zirconium.

13. The conductive paste of claim 12, wherein the metallic glass further comprises at least one selected from aluminum, silver, nickel, titanium, iron, palladium, and hafnium.

14. The conductive paste of claim 13, wherein at least one selected from aluminum, silver, nickel, titanium, iron, palladium, and hafnium is comprised in an amount of 10 atomic percent or less, based on a total amount of the metallic glass.

15. An electrode formed using the conductive paste of any of claims 1-14.

16. The electrode of claim 15, wherein the electrode has a contact resistance of 1 kΩcm² or less.

17. The electrode of claim 15 or 16, wherein the electrode has a resistivity of 10 mΩcm or less.

18. An electronic device comprising an electrode according to any claims 15-17.

19. A solar cell comprising
a semiconductor substrate, and
an electrode according to any of claims 15-17 electrically connected with the semiconductor substrate.

20. The solar cell of claim 19, wherein the electrode comprises a buffer layer positioned at a region which is adjacent to the semiconductor substrate, and an electrode portion which is positioned at a region except the buffer layer.

## Patentansprüche

1. Leitfähige Paste, umfassend:
ein leitfähiges Pulver,
ein metallisches Glas, und
einen organischen Träger,
wobei das metallische Glas eine Legierung von mindestens zwei Elementen umfasst, ausgewählt aus
einem Element, das eine geringe Resistivität aufweist,
einem Element, welches mit dem leitfähigen Pulver einen Mischkristall bildet,
einem Element, das ein hohes Oxidationspotential aufweist,
wobei das Element, das eine geringe Resistivität aufweist, eine Resistivität von weniger als ungefähr 100 Mikroohm-Zentimeter aufweist, und
das Element, das ein hohes Oxidationspotential aufweist, einen absoluten Wert einer Gibbsschen freien Energie der Oxidbildung von ungefähr 100 Kilojoule pro Mol oder mehr aufweist,
wobei das metallische Glas nicht Cu₅₀Zr₅₀, Cu₃₀Ag₃₀Zr₃₀Ti₁₀, Cu₄₃Zr₄₃Al₇Ag₇, Cu₄₆Zr₄₆Al₈, Cu_{58,1}Zr_{35,9}Al₆, Ti₅₀Ni₁₅Cu₃₂Sn₃, Ti₄₅Ni₁₅Cu₂₅Sn₃Be₇Zr₅, Ni₆₀Nb₃₀Ta₁₀, Ni₆₁Zr₂₀Nb₇Al₄Ta₈, Ni_{57,5}Zr₃₅Al_{7,5}, Zr_{41,2}Ti_{13,8}Ni₁₀Cu_{12,5}Be_{22,5}, Mg₆₅Y₁₀Cu₁₅Ag₅Pd₅, Mn₅₅Al₂₅Ni₂₀, La₅₅Al₂₅Ni₁₀Cu₁₀, Mg₆₅Cu_{7,5}Ni_{7,5}Ag₅Zn₅Gd₁₀, Mg₆₅Cu₁₅Ag₁₀Y₆Gd₄, Fe₇₇Nb₆B₁₇, Fe₆₇Mo₁₃B₁₇Y₃, Ca₆₅Mg₁₅Zn₂₀ oder Ca_{66,4}Al_{33,6} ist.

2. Leitfähige Paste nach Anspruch 1, wobei das leitfähige Pulver Silber, Aluminium, Kupfer, Nickel oder eine Kombination davon umfasst.

3. Leitfähige Paste nach Anspruch 1 oder 2, wobei das leitfähige Pulver einen Größenbereich von 1 nm bis 50 µm aufweist.

4. Leitfähige Paste nach einem der Ansprüche 1-3, wobei das Element, das die geringe Resistivität aufweist, eine Resistivität von weniger als 15 Mikroohm-Zentimeter aufweist.

5. Leitfähige Paste nach einem der Ansprüche 1-4, wobei das Element, das die geringe Resistivität aufweist, mindestens eines umfasst, ausgewählt aus Silber, Kupfer, Gold, Aluminium, Calcium, Beryllium, Magnesium, Natrium, Molybdän, Wolfram, Zinn, Zink, Nickel, Kalium, Lithium, Eisen, Palladium, Platin, Rubidium, Chrom und Strontium.

6. Leitfähige Paste nach einem der Ansprüche 1-5, wobei das Element, welches mit dem leitfähigen Pulver den Mischkristall bildet, eine Mischungswärme mit dem leitfähigen Pulver von weniger als 0 KJ/mol aufweist.

7. Leitfähige Paste nach Anspruch 6, wobei das Element, welches mit dem leitfähigen Pulver den Mischkristall bildet, mindestens eines umfasst, ausgewählt aus Lanthan, Cer, Praseodym, Promethium, Samarium, Lutetium, Yttrium, Neodym, Gadolinium, Terbium, Dysprosium, Holmium, Erbium, Thulium, Thorium, Calcium, Scandium, Barium, Ytterbium, Strontium, Europium, Zirconium, Lithium, Hafnium, Magnesium, Phosphor, Arsen, Palladium, Gold, Plutonium, Gallium, Germanium, Aluminium, Zink, Antimon, Silicium, Zinn, Titan, Cadmium, Indium, Platin, Rhodium, Iridium, Uran, Nickel, Ruthenium, Technetium, Mangan, Cobalt, Tantal, Niob, Osmium, Vanadium, Eisen, Chrom, Rhenium, Molybdän, Silber, Wolfram, Beryllium, Bor, Kupfer und Quecksilber.

8. Leitfähige Paste nach einem der Ansprüche 1-7, wobei das Element, welches das hohe Oxidationspotential aufweist, mindestens eines umfasst, ausgewählt aus Kupfer, Titan, Ruthenium, Cadmium, Zink, Rhodium, Kalium, Natrium, Nickel, Bismut, Zinn, Barium, Germanium, Lithium, Strontium, Magnesium, Beryllium, Blei, Calcium, Molybdän, Wolfram, Cobalt, Indium, Silicium, Gallium, Eisen, Zirconium, Chrom, Bor, Mangan, Aluminium, Lanthan, Neodym, Niob, Vanadium, Yttrium und Scandium.

9. Leitfähige Paste nach einem der Ansprüche 1-8, wobei das leitfähige Pulver, das metallische Glas und der organische Träger auf Grundlage eines Gesamtgewichts der leitfähigen Paste in einer Menge von 30 bis 99 Gewichtsprozent, 0,1 bis 20 Gewichtsprozent und 0,9 bis 69,9 Gewichtsprozent eingeschlossen sind.

10. Leitfähige Paste nach einem der Ansprüche 1-9, wobei das metallische Glas im Wesentlichen amorph ist.

11. Leitfähige Paste nach einem der Ansprüche 1-10, wobei das metallische Glas eine unterkühlte Flüssigkeitsregion von 5 °C bis 200 °C aufweist.

12. Leitfähige Paste nach einem der Ansprüche 1-11, wobei das metallische Glas Kupfer und Zirconium umfasst.

13. Leitfähige Paste nach Anspruch 12, wobei das metallische Glas ferner mindestens eines umfasst, ausgewählt aus Aluminium, Silber, Nickel, Titan, Eisen, Palladium und Hafnium.

14. Leitfähige Paste nach Anspruch 13, wobei mindestens eines, ausgewählt aus Aluminium, Silber, Nickel, Titan, Eisen, Palladium und Hafnium auf Grundlage einer Gesamtmenge des metallischen Glases in einer Menge von 10 Atomprozent oder weniger enthalten ist.

15. Elektrode, die unter Verwendung der leitfähigen Paste nach einem der Ansprüche 1-14 gebildet wird.

16. Elektrode nach Anspruch 15, wobei die Elektrode einen Kontaktwiderstand von 1 kΩcm² oder weniger aufweist.

17. Elektrode nach Anspruch 15 oder 16, wobei die Elektrode eine Resistivität von 10 mΩcm oder weniger aufweist.

18. Elektronische Vorrichtung, umfassend eine Elektrode nach einem der Ansprüche 15-17.

19. Solarzelle, umfassend ein Halbleitersubstrat und eine Elektrode nach einem der Ansprüche 15-17, die mit dem Halbleitersubstrat elektrisch verbunden ist.

20. Solarzelle nach Anspruch 19, wobei die Elektrode eine Pufferschicht, die in einer Region positioniert ist, die an das Halbleitersubstrat angrenzt, und einen Elektrodenteil umfasst, welcher in einer Region mit Ausnahme der Pufferschicht positioniert ist.

## Revendications

1. Pâte conductrice comprenant : une poudre conductrice, un verre métallique, et un véhicule organique, dans laquelle le verre métallique comprend un alliage d'au moins deux éléments sélectionnés parmi un élément ayant une faible résistivité, un élément qui forme une solution solide avec la poudre conductrice, un élément ayant un haut potentiel d'oxydation, dans laquelle l'élément ayant une faible résistivité a une résistivité de moins d'environ 100 microohms-centimètres, et l'élément ayant un haut potentiel d'oxydation a une valeur absolue d'une énergie libre de Gibbs de formation d'oxyde d'environ 100 kilojoules par mole ou plus, dans laquelle le verre métallique n'est pas Cu₅₀Zr₅₀, Cu₃₀Ag₃₀Zr₃₀Ti₁₀, Cu₄₃Zr₄₃Al₇Ag₇, Cu₄₆Zr₄₆Al₈, Cu_{58,1}Zr_{35,9}Al₆, Ti₅₀Ni₁₅Cu₃₂Sn₃, Ti₄₅Ni₁₅Cu₂₅Sn₃Be₇Zr₅, Ni₆₀Nb₃₀Ta₁₀, Ni₆₁Zr₂₀Nb₇Al₄Ta₈, Ni_{57,5}Zr₃₅Al_{7,5}, Zr_{41.2}Ti_{13,8}Ni₁₀Cu_{12,5}Be_{22,5}, Mg₆₅Y₁₀Cu₁₅Ag₅Pd₅, Mn₅₅Al₂₅Ni₂₀, La₅₅Al₂₅Ni₁₀Cu₁₀, Mg₆₅Cu_{7,5}Ni_{7,5}Ag₅Zn₅Gd₁₀, Mg₆₅Cu₁₅Ag₁₀Y₆Gd₄, Fe₇₇Nb₆B₁₇, Fe₆₇Mo₁₃B₁₇Y₃, Ca₆₅Mg₁₅Zn₂₀, ou Ca_{66,4}Al_{33,6}.

2. Pâte conductrice selon la revendication 1, dans laquelle la poudre conductrice comprend un argent, un aluminium, un cuivre, un nickel ou une combinaison de ceux-ci.

3. Pâte conductrice selon la revendication 1 ou 2, dans laquelle la poudre conductrice a un ordre de grandeur de 1 nm à 50 µm.

4. Pâte conductrice selon l'une quelconque des revendications 1 à 3, dans laquelle l'élément ayant la faible résistivité a une résistivité de moins de 15 microohms-centimètres.

5. Pâte conductrice selon l'une quelconque des revendications 1 à 4, dans laquelle l'élément ayant la faible résistivité comprend au moins l'un sélectionné parmi l'argent, le cuivre, l'or, l'aluminium, le calcium, le béryllium, le magnésium, le sodium, le molybdène, le tungstène, l'étain, le zinc, le nickel, le potassium, le lithium, le fer, le palladium, le platine, le rubidium, le chrome, et le strontium.

6. Pâte conductrice selon l'une quelconque des revendications 1 à 5, dans laquelle l'élément qui forme la solution solide avec la poudre conductrice a une chaleur de mélange avec la poudre conductrice de moins de 0 KJ/mol.

7. Pâte conductrice selon la revendication 6, dans laquelle l'élément qui forme la solution solide avec la poudre conductrice comprend au moins l'un sélectionné parmi le lanthane, le cérium, le praséodyme, le prométhium, le samarium, le lutétium, l'yttrium, le néodyme, le gadolinium, le terbium, le dysprosium, l'holmium, l'erbium, le thulium, le thorium, le calcium, le scandium, le baryum, l'ytterbium, le strontium, l'europium, le zirconium, le lithium, le hafnium, le magnésium, le phosphore, l'arsenic, le palladium, l'or, le plutonium, le gallium, le germanium, l'aluminium, le zinc, l'antimoine, le silicium, l'étain, le titane, le cadmium, l'indium, le platine, le rhodium, l'iridium, l'uranium, le nickel, le ruthénium, le technétium, le manganèse, le cobalt, le tantale, le niobium, l'osmium, le vanadium, le fer, le chrome, le rhénium, le molybdène, l'argent, le tungstène, le béryllium, le bore, le cuivre, et le mercure.

8. Pâte conductrice selon l'une quelconque des revendications 1 à 7, dans laquelle l'élément ayant le haut potentiel d'oxydation comprend au moins l'un sélectionné parmi le cuivre, le titane, le ruthénium, le cadmium, le zinc, le rhodium, le potassium, le sodium, le nickel, le bismuth, l'étain, le baryum, le germanium, le lithium, le strontium, le magnésium, le béryllium, le plomb, le calcium, le molybdène, le tungstène, le cobalt, l'indium, le silicium, le gallium, le fer, le zirconium, le chrome, le bore, le manganèse, l'aluminium, le lanthane, le néodyme, le niobium, le vanadium, l'yttrium, et le scandium.

9. Pâte conductrice selon l'une quelconque des revendications 1 à 8, dans laquelle la poudre conductrice, le verre métallique, et le véhicule organique sont inclus dans une quantité de 30 à 99 pour cent en poids, 0,1 à 20 pour cent en poids, et 0,9 à 69,9 pour cent en poids sur la base d'un poids total de la pâte conductrice.

10. Pâte conductrice selon l'une quelconque des revendications 1 à 9, dans laquelle le verre métallique est substantiellement amorphe.

11. Pâte conductrice selon l'une quelconque des revendications 1 à 10, dans laquelle le verre métallique a une région liquide surfondue de 5 °C à 200 °C.

12. Pâte conductrice selon l'une quelconque des revendications 1 à 11, dans laquelle le verre métallique comprend du cuivre et du zirconium.

13. Pâte conductrice selon la revendication 12, dans laquelle le verre métallique comprend en outre au moins l'un sélectionné parmi l'aluminium, l'argent, le nickel, le titane, le fer, le palladium, et le hafnium.

14. Pâte conductrice selon la revendication 13, dans laquelle au moins l'un sélectionné parmi l'aluminium, l'argent, le nickel, le titane, le fer, le palladium, et le hafnium est compris dans une quantité de 10 pour cent atomique ou moins, sur la base d'une quantité totale du verre métallique.

15. Électrode formée en utilisant la pâte conductrice selon l'une quelconque des revendications 1 à 14.

16. Électrode selon la revendication 15, dans laquelle l'électrode a une résistance au contact de 1 kΩcm² ou moins.

17. Électrode selon la revendication 15 ou 16, dans laquelle l'électrode a une résistivité de 10 mΩcm ou moins.

18. Dispositif électronique comprenant une électrode selon l'une quelconque des revendications 15 à 17.

19. Cellule solaire comprenant un substrat semi-conducteur, et une électrode selon l'une quelconque des revendications 15 à 17 connectée électriquement avec le substrat semi-conducteur.

20. Cellule solaire selon la revendication 19, dans laquelle l'électrode comprend une couche tampon positionnée au niveau d'une région qui est adjacente au substrat semi-conducteur, et une partie d'électrode qui est positionnée au niveau d'une région autre que la couche tampon.
